**Europäisches Patentamt**

**European Patent Office**

**Office européen des brevets**

(11) Veröffentlichungsnummer: **0 137 896**
**B1**

(19)

(12) **EUROPÄISCHE PATENTSCHRIFT**

(45) Veröffentlichungstag der Patentschrift:
20.07.88

(21) Anmeldenummer: **84104472.0**

(22) Anmeldetag: **19.04.84**

(51) Int. Cl.⁴: **G 01 R 33/02**

(54) Schaltungsanordnung zur Kompensation von Schwankungen des Uebertragungsfaktors eines linearen Magnetfeldsensors.

(30) Priorität: **08.08.83 CH 4448/83**

(43) Veröffentlichungstag der Anmeldung:
**24.04.85 Patentblatt 85/17**

(45) Bekanntmachung des Hinweises auf die Patenterteilung:
**20.07.88 Patentblatt 88/29**

(84) Benannte Vertragsstaaten:
**AT DE FR GB NL SE**

(56) Entgegenhaltungen:
**EP-A-0 018 750**
**DE-B-1 297 755**
**DE-B-2 719 073**
**US-A-4 013 946**

(73) Patentinhaber: **LGZ LANDIS & GYR ZUG AG, CH-6301 Zug (CH)**

(72) Erfinder: **Gruber, Peter, Mühlebergstrasse 13, CH-8910 Affoltern (CH)**
Erfinder: **steinle, Benedikt, Schönbühl 10, CH- 6300 Zug (CH)**

EP 0 137 896 B1

## Beschreibung

Die Erfindung bezieht sich auf eine Schaltungsanordnung zur Kompensation von Schwankungen des Übertragungsfaktors eines linearen Magnetfeldsensors der im Oberbegriff des Anspruchs 1 genannten Art.

Es ist bekannt, einen elektrischen Strom über das von ihm erzeugte Magnetfeld potentialfrei zu messen. Zur Ermittlung der Stärke des Magnetfeldes dienen Magnetfeldsensoren, z. B. Hallgeneratoren, Magnetotransistoren und andere Halbleiterelemente, die ein zum Magnetfeld mehr oder weniger proportionales Ausgangssignal erzeugen. Um den Einfluss von Nichtlinearitäten und Schwankungen der Steigung der Übertragungskennlinie des Magnetfeldsensors auf das Messresultat zu eliminieren, kann mittels eines Regelkreises und einer Magnetspule ein magnetisches Gegenfeld erzeugt werden, welches das zu messende Magnetfeld praktisch vollständig kompensiert (DE-B-26 21 302). Nachteilig bei solchen sogenannten kompensierten Wandlern ist der verhältnismässig hohe Leistungsaufwand zur Erzeugung des kompensierenden Magnetfeldes.

Manche der bekannten Magnetfeldsensoren zeichnen sich durch eine befriedigende Linearität der Übertragungskennlinie aus, wobei jedoch die Steigung der Übertragungskennlinie eine Funktion der Temperatur darstellt und auch alterungsbedingten Änderungen unterworfen ist. Es ist bekannt (EP-A-00 18 750), bei einem an sich linearen, als Magnetfeld/Frequenzwandler arbeitenden Magnetfeldsensor mit Hilfe eines magnetischen Gleichfeldes die Steigung der Übertragungskennlinie zu bestimmen und die Ausgangsfrequenz durch eine der Steigung proportionale Frequenz zu dividieren, so dass Schwankungen der Steigung kompensiert werden. Diese Art der Bestimmung der Steigung setzt jedoch voraus, dass einerseits das zu messende Magnetfeld ein reines Wechselfeld ist und das andererseits die Übertragungskennlinie des Magnetfeldsensors keinen Offset aufweist.

Aus der DE-B-1 297 755 ist ausserdem eine Schaltungsanordnung bekannt, in der ein von einem Gleichstrom durchflossener magnetfeldabhängiger Widerstand einem zu messenden Magnetfeld ausgesetzt ist, dem ein sich z. B. zeitlich rechteckförmig schnell änderndes magnetisches Wechselfeld überlagert ist, welches mittels einer von einem Wechselstrom durchflossenen Spule erzeugt wird. Dabei wird eine Eigenschaft der magnetfeldabhängigen Widerstände ausgenutzt, nämlich dass die Symmetrie ihrer Kennlinie von Natur aus temperaturunabhängig ist, um ohne Kompensationsschaltung temperaturunabhängige Messungen zu realisieren.

Der Erfindung liegt die Aufgabe zugrunde, eine Schaltungsanordnung der eingangs genannten Art mit einem Magnetfeld/Spannungswandler als Magnetfeldsensor zu bestücken und derart auszugestalten, dass durch Temperatur und Alterungseinflüsse bedingte Schwankungen der Steigung der Übertragungskennlinie des Magnetfeldsensors einwandfrei kompensiert werden.

Die Lösung dieser Aufgabe gelingt durch die im Anspruch 1 angegebenen Merkmale.

In einer bevorzugten Ausführung erfolgt die Kompensation auch dann einwandfrei, wenn der Magnetfeldsensor eine Offset-Spannung aufweist und wenn das zu messende Magnetfeld eine Gleichstromkomponente besitzt.

Nachfolgend wird ein Ausführungsbeispiel der Erfindung anhand der Zeichnung näher erläutert.

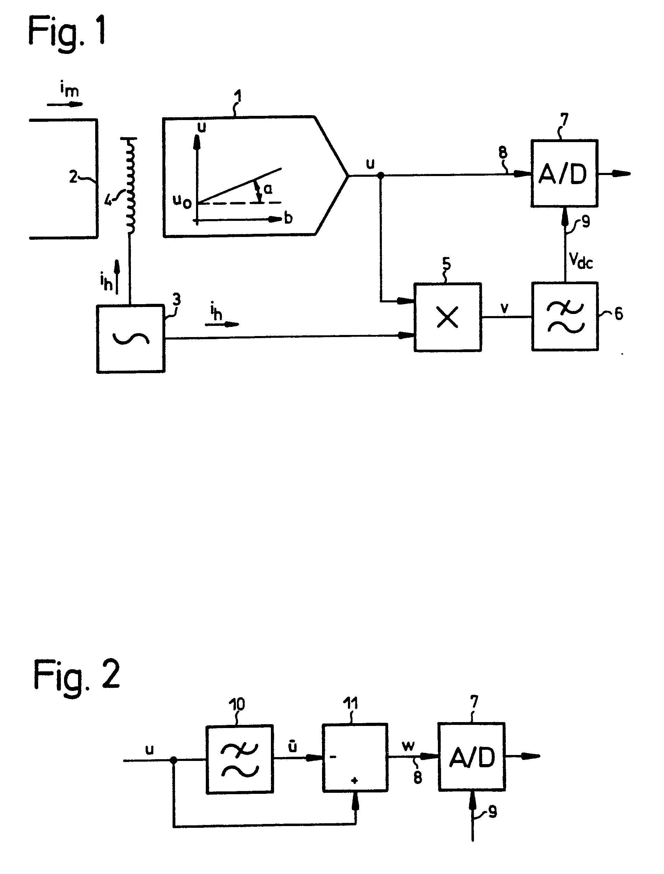

Es zeigen: Fig. 1 ein Prinzipschaltbild und Fig. 2 ein Detail einer Variante der Schaltungsanordnung nach der Fig. 1.

In der Fig. 1 bedeutet 1 einen Magnetfeldsensor, der einem zu messenden Magnetfeld ausgesetzt ist, an seinem Ausgang eine Spannung u in Abhängigkeit von diesem Magnetfeld abgibt und somit als Magnetfeld/Spannungswandler arbeitet. Dieser Magnetfeldsensor 1 kann z. B. ein Hallgenerator, ein MOS-Magnetotransistor oder eine MOS-Magnetodiode sein. Für die Ausgangsspannung u des Magnetfeldsensors 1 gilt die Beziehung $u = u_0 + a.b$, wobei $u_0$ die gegebenenfalls vorhandene Offset-Spannung, a die Steigung der linearen Übertragungskennlinie und b die magnetische Flussdichte im Magnetfeldsensor 1 bedeutet. Die Steigung a ist eine Funktion der Temperatur und zudem auch alterungsbedingten Schwankungen unterworfen, so dass trotz der guten Linearität der Übertragungskennlinie ohne besondere Massnahmen eine genaue Messung des Magnetfeldes nicht möglich ist.

Der Magnetfeldsensor 1 kann zur Messung eines in einem elektrischen Leiter 2 fliessenden Meßstromes $i_m$ über das von ihm erzeugte Magnetfeld dienen. Die Einkopplung des vom Meßstrom $i_m$ erzeugten Magnetfeldes in den Magnetfeldsensor 1 kann in bekannten Weise mittels eines Magnetkernes oder auch ohne einen Magnetkern dadurch erfolgen, dass der Magnetfeldsensor 1 auf der Oberfläche des als Flachleiter ausgebildeten Leiters 2 angeordnet wird.

Mit Hilfe einer Stromquelle 3, einer Magnetspule 4 und eines aus einem Multiplikator 5 und einem Tiefpass 6 bestehenden Korrelators wird die Steigung a der Übertragungskennlinie bestimmt, und mittels eines als Divisionsglied arbeitenden Analog/Digitalwandlers 7 wird zur Kompensation von temperatur- oder alterungsbedingten Schwankungen der Steigung a die Division $\frac{u}{a}$ durchgeführt.

Die Stromquelle 3 erregt die Magnetspule 4 mit einem Hilfsstrom $i_h$, der ein Wechselstrom oder ein pulsierender Gleichstrom ist. Die Magnetspule 4 erzeugt ein alternierendes oder pulsierendes magnetisches Hilfsfeld bekannter Grösse und mit bekanntem zeitlichem Verlauf. Sie ist so angeordnet, dass dieses Hilfsfeld dem zu messenden Magnetfeld überlagert wird. Die Amplitude des Hilfsfeldes beträgt einige Prozent des Maximalwertes der Amplitude des zu messenden Magnetfeldes.

Der Ausgang des Magnetfeldsensors 1 ist mit dem Signaleingang 8 des Analog/Digitalwandlers 7 verbunden. Der Multiplikator 5 besitzt zwei Eingänge, von denen der eine an den Ausgang des Magnetfeldsensors 1 und der andere an die Stromquelle 3 angeschlossen ist. Der Ausgang des Multiplikators 5 ist über den Tiefpass 6 an einen Referenzspannungseingang 9 des Analog/Digitalwandlers 7 angeschlossen.

Die beschriebene Schaltungsanordnung arbeitet wie folgt:

Der Magnetfeldsensor 1 erfasst die Summe des zu messenden Magnetfeldes und des vom Hilfsstrom $i_h$ erzeugten Magnetfeldes. Für die Ausgangsspannung u des Magnetfeldsensors 1 gilt

$$u = u_o + a(b_m + b_h)$$

wobei $b_m$ die durch den Meßstrom und $i_m$ und $b_h$ die durch den Hilfsstrom $i_h$ erzeugte magnetische Flussdichte bedeutet. $u_o$ ist in der Regel vernachlässigbar klein und kann auf die weiter unten beschriebene Weise eliminiert werden. Auch die durch den Hilfsstrom $i_h$ verursachte Komponente $a.b_h$ der Ausgangsspannung u kann erforderlichenfalls durch ein in der Zeichnung nicht dargestelltes Filter herausgefiltert werden, da der zeitliche Verlauf dieser Komponente bekannt ist. Der Analog/Digitalwandler 7 wandelt die Ausgangsspannung u bzw. die nach der Elimination der störenden Komponenten noch verbleibende Komponente $a.b_m$ in ein digitales Signal um.

Der Multiplikator 5 bildet das Produkt $v = u.i_h$ der zeitveränderlichen Grössen u und $i_h$. Die Gleichstromkomponente $V_{dc}$ dieses Produktes entspricht dem allein durch das Hilfsmagnetfeld erzeugten Anteil der Ausgangsspannung u und ist zur Steigung a proportional. Der Tiefpass 6 lässt die Gleichstromkomponente $V_{dc}$ des Signals v durch und sperrt dessen übrige Komponenten. Die Gleichstromkomponente $V_{dc}$ gelangt als Referenzspannung zum Analog/Digitalwandler 7. Der Übertragungsfaktor des Analog/Digitalwandlers 7 ist proportional zum Reziprokwert der Referenzspannung, so dass dieser Wandler die Division $\frac{u}{V_{dc}}$ bzw. $\frac{u}{a}$ durchführt und das digitale Messergebnis von der Steigung a unabhängig ist.

Es ist leicht ersichtlich, dass die beschriebene Messeinrichtung sowohl zur Messung von Wechselströmen bzw. magnetischer Wechselfelder als auch von Gleichströmen bzw. magnetischer Gleichfelder geeignet ist. Der zeitliche Verlauf des Hilfsstromes $i_h$ ist derart zu wählen, dass Korrelationen mit dem zu messenden Magnetfeld vermieden werden. Zur Messung von 50 Hz-Wechselfeldern eignet sich beispielsweise ein sinusförmiger Hilfsstrom $i_h$ mit einer Frequenz von einigen kHz. Besonders vorteilhaft ist es, die Stromquelle 3 als Pseudo-Zufalls-Stromquelle auszubilden. Falls der zeitliche Verlauf des Hilfsstromes $i_h$ rechteckförmig ist, kann als Multiplikator 5 ein Umpolschalter verwendet werden, der die Polarität der Ausgangsspannung u im Takt des Hilfsstromes $i_h$ umpolt.

Die beschriebene Kompensation von Schwankungen der Steigung a gewährleistet eine hohe Messgenauigkeit und reduziert in hohem Masse die Anforderungen an die Stabilität des Magnetfeldsensors 1. Die Verwendung des Analog/Digitalwandlers 7 als Divisionsglied ergibt einen besonders einfachen Schaltungsaufbau und erübrigt eine stabilisierte Gleichspannungsquelle zur Erzeugung der Referenzspannung für diesen Wandler. Da das magnetische Hilfsfeld gegenüber dem zu messenden Magnetfeld schwach sein kann, erfordert die Erzeugung des Hilfsfeldes im Vergleich zu dem eingangs erwähnten kompensierten Wandlers einen wesentlich geringeren Leistungsaufwand.

Wenn eine allfällige Gleichfeldkomponente des zu messenden Magnetfeldes von der Messung nicht erfasst werden soll, kann zwischen den Ausgang des Magnetfeldsensors 1 und den Signaleingang 8 des Analog/Digitalwandlers 7 ein Filter geschaltet werden, das die in der Ausgangsspannung u enthaltene Gleichstromkomponente sperrt. Durch diese Massnahme wird auch die Offset-Spannung $u_o$ des Magnetfeldsensors 1 eliminiert. Das genannte Filter besteht gemäss der Fig. 2 vorteilhaft aus einem Tiefpassglied 10 und einem Subtrahierglied 11, wobei der Ausgang des Magnetfeldsensors 1 (Fig. 1) an den Eingang des Tiefpassgliedes 10 sowie an den "+"-Eingang des Subtrahiergliedes 11, der Ausgang des Tiefpassgliedes 10 an den "-"-Eingang des Subtrahiergliedes 11 und der Ausgang des Subtrahiergliedes 11 an den Signaleingang 8 des Analog/Digitalwandlers 7 angeschlossen ist. Die Gleichstromkomponente $\bar{u}$ der Ausgangsspannung u gelangt über das Tiefpassglied 10 zum Subtrahierglied 11, an dessen Ausgang das Differenzsignal $w = u - \bar{u}$ entsteht.

Schliesslich ist es auch möglich, die Elimination der Gleichstromkomponente $\bar{u}$ erst nach der Analog/Digitalumwandlung durch digitale Filterung vorzunehmen.

## Patentansprüche

1. Schaltungsanordnung zur Kompensation von Schwankungen des Übertragungsfaktors eines linearen Magnetfeldsensors (1), mit einer an eine Stromquelle (3) angeschlossenen Magnetspule (4) zur Erzeugung eines dem zu messenden Magnetfeld überlagerten Hilfsmagnetfeldes, mit Mitteln (5-6) zur Bestimmung der Steigung der Übertragungskennlinie des Magnetfeldsensors durch Ermittlung des allein durch das Hilfsmagnetfeld erzeugten Anteils des Ausgangssignals des Magnetfeldsensors und mit einem Divisionsglied (7) zur Division des Ausgangssignals durch die Steigung, dadurch gekennzeichnet, dass der Magnetfeldsensor (1) ein Magnetfeld/Spannungswandler ist, dass der von der Stromquelle (3) erzeugte Hilfsstrom ($i_h$) ein Wechselstrom oder pulsierender Gleichstrom ist, dass der Ausgang des Magnetfeldsensors (1) und die Stromquelle (3) an einen Multiplikator (5) angeschlossen sind und dass der Ausgang des Multiplikators (5) über einen Tiefpass (6) an das Divisionsglied (7) geschaltet ist.

2. Schaltungsanordnung nach Anspruch 1, dadurch gekennzeichnet, dass das Divisionsglied (7) ein Analog/Digitalwandler ist, dessen Signaleingang (8) mit dem Ausgang des Magnetfeldsensors (1) und dessen Referenzspannungseingang (9) mit dem Ausgang des Tiefpasses (6) verbunden ist.

3. Schaltungsanordnung nach Anspruch 1 oder 2, dadurch gekennzeichnet, dass zwischen den Ausgang des Magnetfeldsensors (1) und das Divisionsglied (7) ein Filter (10, 11) geschaltet ist, das die im Ausgangssignal (u) des Magnetfeldsensors (1) enthaltene Gleichstromkomponente (ū) sperrt.

4. Schaltungsanordnung nach Anspruch 3, dadurch gekennzeichnet, dass das Filter aus einem Tiefpassglied (10) und einem Subtrahierglied (11) besteht.

5. Schaltungsanordnung nach einem der Ansprüche 1 bis 4, dadurch gekennzeichnet, dass die Stromquelle (3) eine Pseudo-Zufalls-Stromquelle ist.

**Claims**

1. A circuit arrangement for compensating for fluctuations in the transmission factor of a linear magnetic field sensor (1) comprising a magnetic coil (4) connected to a current source (3) for producing an auxiliary magnetic field which is superimposed on the magnetic field to be measured, means (5-6) for determining the slope of the transmission characteristic of the magnetic field sensor by ascertaining the component, which is produced solely by the auxiliary magnetic field, of the output signal of the magnetic field sensor, and a division member (7) for division of the output signal by the slope, characterised in that the magnetic field sensor (1) is a magnetic field/voltage transducer, that the auxiliary current ($i_h$) produced by the current source (3) is an alternating current or pulsating direct current, that the output of the magnetic field sensor (1) and the current source (3) are connected to a multiplier (5) and that the output of the multiplier (5) is connected by way of a low pass filter (6) to the division member (7).

2. A circuit arrangement according to claim 1 characterised in that the division member (7) is an analog/digital converter whose signal input (8) is connected to the output of the magnetic field sensor (1) and whose reference voltage input (9) is connected to the output of the low pass filter (6).

3. A circuit arrangement according to claim 1 or claim 2 characterised in that connected between the output of the magnetic field sensor (1) and the division member (7) is a filter (10, 11) which blocks the direct current component (ū) contained in the output signal (u) of the magnetic field sensor (1).

4. A circuit arrangement according to claim 3 characterised in that the filter comprises a low pass member (10) and a subtracting member (11).

5. A circuit arrangement according to one of claims 1 to 4 characterised in that the current source (3) is a pseudo-random current source.

**Revendications**

1. Circuit de compensation de variations du facteur de transmission d'un capteur linéaire de champ magnétique (1), comportant une bobine magnétique (4) reliée à une source de courant (3) pour produire un champ magnétique auxiliaire superposé au champ magnétique à mesurer, des moyens (5-6) pour définir la pente de la courbe caractéristique de transmission du capteur de champ magnétique par détermination de la partie du signal de sortie du capteur de champ magnétique qui est produite uniquement par le champ magnétique auxiliaire, ainsi qu'un organe de division (7) pour diviser le signal de sortie par la pente, caractérisé en ce que le capteur de champ magnétique (1) est un convertisseur champ magnétique/ tension, en ce que le courant auxiliaire ($i_h$) produit par la source de courant (3) est un courant alternatif ou un courant continu impulsionnel, en ce que la sortie du capteur de champ magnétique (1) et la source de courant (3) sont reliées à un multiplicateur (5) et en ce que la sortie du multiplicateur (5) est reliée par l'intermédiaire d'un filtre passe-bas (6) à l'organe de division (7).

2. Circuit selon la revendication 1, caractérisé en ce que l'organe de division (7) est un convertisseur analogique/numérique, dont l'entrée de signal (8) est reliée à la sortie du capteur de champ magnétique (1) et dont l'entrée de tension de référence (9) est reliée à la sortie du filtre passe-bas (6).

3. Circuit selon une des revendications 1 ou 2, caractérisé en ce qu'il est prévu entre la sortie du capteur de champ magnétique (1) et l'organe de division (7) un filtre (10, 11) qui arrête la composante de courant continu (ū) contenue dans le signal de sortie (u) du capteur de champ magnétique (1).

4. Circuit selon la revendication 3, caractérisé en ce que le filtre se compose d'un organe passe-bas (10) et d'un organe de soustraction (11).

5. Circuit selon une des revendications 1 à 4, caractérisé en ce que la source de courant est une source de courant pseudo-aléatoire.

# Fig. 1

# Fig. 2